# EUROPEAN PATENT APPLICATION

(11) **EP 4 712 727 A1**
(43) Date of publication of application: **18.03.2026**
(21) Application number: 24211274.6
(22) Date of filing: 06.11.2024
(51) Int. Cl.: H10D 62/80, H01L 21/20, B82Y 40/00

(54) **NANOELECTRONIC DEVICES COMPRISING PATTERNED THIN FILMS AND METHOD FOR PRODUCING THE SAME**

(30) Priority: 16.09.2024 EP 24200503
(71) Applicant: Ecole Polytechnique Fédérale de Lausanne (EPFL), 1015 Lausanne (CH)
(72) Inventor: Erbas, Berke, 1025 St-Sulpice (CH); Brugger, Juergen, 1302 Vufflens-la-Ville (CH); Kis, Andras, 1024 Ecublens (CH); Bala, Arindam, 1004 Lausanne (CH)
(74) Representative: Vesterinen, Jussi Tapio

(57) **Abstract**

The present invention relates to a method for straining a two-dimensional layer of solid material (5) in a nanoelectronic device. The method comprises the steps of providing a substrate; adding a thin film onto the substrate to be in direct contact with the substrate (4), or onto one of one or more first interlayers placed on the substrate (4) to be in indirect contact with the substrate (4); patterning the thin film; and adding, through a high-temperature process, a two-dimensional layer of solid material onto the patterned thin film (3) to be in direct contact with the patterned thin film (3), or onto one of one or more second interlayers placed on the patterned thin film (3) to be in indirect contact with the patterned thin film (3).

## Description

### TECHNICAL FIELD

The present invention belongs to the field of nanoelectronic devices embedding a two-dimensional semiconductor layer, particularly suitable for bandgap modulation, as well as to microfabrication methods for producing the device.

### BACKGROUND OF THE INVENTION

The integration of emerging two-dimensional (2D) materials, particularly 2D semiconductors, in commercial devices is extensively studied because these materials are expected to outperform current state-of-the-art materials and extend Moore's law by further scaling dimensions.

Atomically thin, 2D materials such as graphene and transition metal dichalcogenides (TMDCs) continue to be considered viable key components for diverse nanoelectronics applications and future applications in micro/nano devices and systems. This is mainly due to their atomically thin structures and extraordinary properties beyond bulk counterparts, enabling applications where for instance flexibility and stretchability are important.

To produce nanostructures of 2D materials, top-down techniques such as photolithography, electron beam lithography (EBL), and ion beam lithography (IBL) are typically used. It has been recently observed that the lithographic techniques using electrons or ions may induce structural damage in 2D materials, or they add resist contaminations that need to be removed by plasma cleaning. Laser ablation is a resist-free, one-step alternative, but the optical diffraction limit prevents its use where sub-micrometer resolution is required. Bottom-up techniques, like chemical vapor deposition and site-selective growth, allow for scalability and high resolution. However, reproducible fabrication of complex device structures and device integration remain still unsolved.

The capability of producing high-quality 2D material nanostructures with well-defined geometries at high resolution is a critical requirement for fostering 2D material-based applications. For instance, patterning thin film materials into finite structures with nanometer-scale confinement is important for tuning their electronic transport properties, but remains a major challenge. Scaling of electronic devices to smaller dimensions also increases the device density and reduces power consumption.

As a way of example, developing a controllable and reproducible strain engineering method, enabling the tailored design of the bandgap of 2D materials, is of significant importance for electronic and optoelectronic devices. Straining thin 2D materials (2DMs) can create new artificial materials with broader electronic and optoelectronic properties, as well as practical applications for high-performance strain-engineered 2D devices and flexible electronics. Existing methods of straining 2DMs mainly include stretching/compressing the supporting substrate or transferring the 2DM on a topographically patterned surface. Though various types of strategies have been proposed to strain 2DMs, more versatile approaches for modulating the magnitude and spatial distribution of the strain would be valuable for further fundamental studies and applications.

Besides pushing the magnitude of the strain, the ability to apply a spatially controllable strain at nanoscale is crucial to precisely manipulate the local properties of 2DMs. The challenge of substrate-induced approaches is that the amount of transferred strain, as well as its crystallographic orientation, are not easily controlled.

Strain engineering is an effective way to modify the band structure and phonon dispersion of 2D semiconductors, influencing their electrical, optical, and thermal properties. For example, strain in 2D semiconductors suppresses electron-phonon scattering, which directly enhances electrical conductivity and carrier mobility. The use of thermally actuated micromechanical devices, substrate heating, thermomechanical nanoindentation, bulging devices with pressurized components, tip indentation to stretch 2DMs via direct contact, and the bending and/or stretching of flexible polymer substrates have been employed to induce strain and study its physical effects in 2DMs. However, these techniques are not compatible with fabrication of nanoscale devices with high-density integration capabilities.

Strain induced by thermal expansion mismatch between the substrate and the grown 2D material is reported as an alternative technique by Ahn et al. (Strain-engineered growth of two-dimensional materials. doi:10.1038/s41467-017-00516-5). This method requires selecting specific substrates to induce global strain throughout the grown materials. However, substrates for devices are generally chosen based on the application, and there remains a need for strained materials with enhanced performance on application-defined substrates.

Strain engineering of atomically thin materials using pre-patterned substrates has also been studied. 2D materials strained on pre-patterned crested substrates through mechanical deformation, typically achieved by pressing the materials against substrates with polymer support, have successfully demonstrated enhanced performance in optical and electrical devices due to the induced strain effects. However, the use of pre-structured substrates often results in wrinkled, ripped, crested and suspended 2DMs, leading to unpreferred unstable semiconductor-dielectric interfaces, which limits device downscaling and performance. Additionally, material transfer typically requires detaching atomically thin material from the growth substrate, aligning it, and transferring it to the target substrate using a polymer stack. This process often introduces defects in the grown materials and necessitates additional chemical cleaning steps to eliminate polymer residues.

Direct growth on pre-structured substrates has been shown to modify a few nanometer thick MoS₂ layer. Martella et al. (Anisotropic MoS2 Nanosheets Grown on Self-Organized Nanopatterned Substrates. Adv. Mater. 29, (2017)) demonstrated that it is possible to induce anisotropy in 2D materials on rippled patterns with random height distribution but directionality along one axis. They exemplified this on MoS₂ sheets fabricated by the sulfurization of molybdenum oxide. The random ripple shapes resulted in random anisotropic sulfurization, leading to an anisotropic MoS₂ sheet. Although they did not observe peak shifts in Raman active phonon modes, which are the main indicators of strain in 2D materials, they reported deconvoluted hidden peak shifts due to Raman peak broadening. The peak broadening observed in their work is attributed to random strain from arbitrary and anisotropic sulfurization and local charge doping caused by defects during the growth process. Additionally, they showed that anisotropy in the targeted direction is not continuous but is randomly observed on rippled substrates.

In another study, Wang et al. (Thermally Strained Band Gap Engineering of Transition-Metal Dichalcogenide Bilayers with Enhanced Light-Matter Interaction toward Excellent Photodetectors. ACS Nano 11, 8768-8776 (2017)) demonstrated the use of conical and pyramidal shape-patterned sapphire substrate to induce compressive strain on MoS₂ bilayers. These bilayers were fabricated by sulfurizing the deposited molybdenum trioxide on the pre-structured substrate. A compressive strain of up to 0.05% was achieved on the MoS₂ layers due to the difference in thermal expansion coefficients between the lateral and vertical directions of sapphire, with the thermal expansion coefficient of the c-plane being smaller than that of the plane perpendicular to the c-axis. According to theoretical predictions, the maximum achievable strain is only 0.07% and is compressive.

### SUMMARY OF THE INVENTION

The present invention presents a scalable method for inducing deterministic local strain in 2D materials during their growth on multi-level-dimensioned (also known as grayscale) topographies, such as topographies having rounded, curved and/or angled side profiles, including sinusoidal, triangular and trapezoidal patterns. By precisely varying the aspect ratios of these patterns, the inventors proved able to achieve localized control over the bandgap of 2D materials, creating strain gradients within a single 2D material flake (i.e. a portion of 2D material on a thin film) and resulting in regionally distinct bandgaps. Additionally, the design of patterns allows for control over both the magnitude and orientation of the strain depending on crystallographic orientation of synthesized/grown/deposited material. This approach advantageously eliminates the need for complex material transfer processes, such as detachment, alignment, and transfer using a polymer stack, by facilitating the direct growth of 2D materials to induce strain with well-defined orientation and control of the bandgap, making the process reproducible. This scalable and reproducible technique ensures a fully conformal attachment of 2D materials to the underlying dielectric material, creating a stable and ideal semiconductor-dielectric interface crucial for electronics and optics applications. Conformal attachment refers to a method of joining or connecting materials in a way that maintains a close fit and follows the contours of the surfaces being joined. This technique ensures minimal gaps or misalignment, which can enhance performance and stability.

According to a first aspect of the present invention, there is provided a method for patterning a thin film of a solid material as recited in claim 1.

Accordingly, the present invention relates to multi-level depth patterning of thin film layers deposited on substrates to induce localized *in-situ* tensile strain in 2D materials, such as monolayer MoS₂, during the growth process and to precisely adjust their bandgaps. The multiple levels may be continuous levels, i.e. the levels change in a continuous manner, when looking at the side profile of the device. This technique controls surface lengths where the 2D material grows and preferably benefits from the thermal expansion mismatch between the 2D material and the substrate, as well as the stress induced in the thin-film layer due to the thermal expansion mismatch between the substrate and the thin film. For example, through this method, one can achieve approximately 1% tensile strain in MoS₂, even on sapphire substrates that ideally do not induce strain due to their thermal expansion coefficients, which are nearly identical to that of MoS₂. Moreover, unlike the substrate engineering proposed in the art, the present technique introduces additional tensile strain specifically in the patterned areas of the substrates.

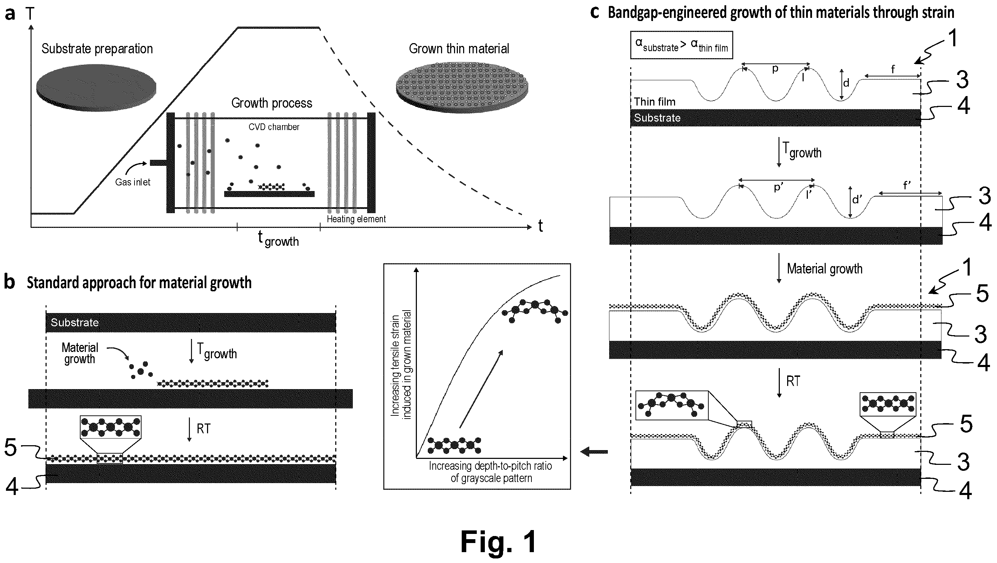

This technique uses the high-temperature synthesis, growth or deposition of a thin material, such as a 2D material, onto an intermediate layer, i.e. the thin film, which is thinner than the substrate (the thickness of the thin film material ranging from nanometers to micrometers, e.g., thin-film dielectric oxide with hundreds of nanometers thickness), deposited on the thicker substrate, which can be made of any hard or flexible material with a thickness greater than a micrometer. The substrate does not have to be flat, but it may instead have any arbitrary shape cross-sectionally along the longitudinal axis of the device. Alternatively, or in addition, the substrate may have any shape when seen from the top. For tensile strain, the substrate advantageously has a higher thermal expansion coefficient than the thin-film material, and the growth temperature is higher than room temperature. Conversely, for compressive strain, the substrate advantageously has a lower thermal expansion coefficient than the thin film. Thus, advantageously, the substrate is characterised by a first thermal expansion coefficient, and the thin film is characterised by a second thermal expansion such that the first thermal expansion coefficient is different from the second thermal expansion coefficient. If tensile strain is desired, preferably, the first thermal expansion coefficient is at least 2 × 10⁻⁶ K⁻¹ higher than the second thermal expansion coefficient to obtain a reasonable tensile strain. For example, the thermal expansion coefficient of SiO₂ thin film is approximately 0.25 × 10⁻⁶ K⁻¹, and doubling this value does not yield a reasonable strain, but for Si₃N₄ thin film the thermal expansion coefficient is approximately 3.3 × 10⁻⁶ K⁻¹, and doubling this value will be sufficient. The left-hand side of Figure 1 illustrates the state-of-the art process, and the right-hand side of Figure 1 illustrates the process according to the present invention.

The nature of the strain arises from the elongation of the 2D material or thin materials due to the difference between the surface length on grayscale patterns and flat patterns. When 2D materials grown (or thin material synthesized or deposited) at high temperatures cool down to room temperature, they shrink. On the flat parts of the thin-film layer, this shrinkage is proportional to that of the substrate. However, the surface length on grayscale patterns does not shrink proportionally when cooled down to room temperature. The final dimensions of the 2D materials and thin layers are defined by the surface length at room temperature due to the strong adhesion between the 2D material and the surface of the thin film layer having a direct or an indirect contact interface with the 2D material. The adhesion between the 2D material and the underlying surface ensures that strain is maintained.

The main reasons for the non-shrinkage in grayscale surface length are twofold: (i) lateral elongation (i.e. along horizontal directions if the device is placed on a horizontal surface) in the thin-film layer due to the thermal expansion mismatch between the substrate and the thin-film layer, and (ii) shrinkage in the height of the thin-film layer, proportional to its Poisson ratio, due to tensile strain induced by the substrate.

### Fabrication details:

To obtain a device with a conductive or dielectric layer between the 2D material and the thin-film layer, the top surface of the thin-film layer can be coated with any electrically conductive or dielectric material using techniques such as atomic layer deposition (ALD) or chemical vapor deposition (CVD). Subsequently, 2D materials can be grown on the deposited conductive or dielectric layer to achieve an optimal 2D/conductive or 2D/dielectric interface. Further layers of dielectric and 2D materials can be sequentially synthesized/grown/deposited to create stacked channels. After synthesis/growth/deposition of the 2D material on the patterned thin film, the 2D material, and in particular its top side or face, can be further patterned into specific shapes. This enables isolation of certain areas within the 2D material, creating defined (isolated) regions that can, for example, serve as a semiconductor channel in transistor devices if the grown 2D material is a semiconductor.

Grayscale patterns, or non-binary multi-level dimension patterns when the device is seen cross-sectionally along the longitudinal axis of the device in side view, can be directly or indirectly created on thin-film layers using patterning techniques, such as lithography and etching. Alternatively, these patterns can be formed on a resist layer through methods, such as photolithography, interference lithography, electron beam lithography, scanning probe lithography, and nanoimprint lithography, and then transferred to the underlying thin-film layer. Rounded, curved and angled shapes can be achieved with any industry-standard lithography and dry etching combined techniques. By benefiting from rounding effects at the nanoscale or different vertical lateral etch rates during etching steps after lithography patterning, rounded, curved and/or angled shapes, including sinusoidal, triangular, trapezoidal, and/or dome shapes can be obtained.

According to the theoretical calculations, any thin layer materials, such as a silicon layer deposited and/or grown and/or synthesized on rounded, curved or angled fin shapes (when considering their side profile) will be exposed to mechanical strain as well. Therefore, not only 2D monolayer materials but also silicon gate-all-around FETs (GAAFETs), which are expected to be used in the near future, could also benefit from the present invention. This results in generalization of the idea beyond 2D materials.

Advantages:
- Deterministic local strain in 2D materials after growing them on multi-level-dimensioned, also known as grayscale (e.g., rounded, curved and/or angled) topographies;
- Varying bandgap of 2D materials depending on the aspect ratio, also referred to as depth-to-pitch ratios, of patterns on the thin-film layer or on the 2D material;
- Deterministic control of bandgap and strain induced in 2D materials depending on the depth-to-pitch ratios of topographies;
- Strain gradients within the same 2D material flake obtained by adjusting the width and height (and depth and pitch) of the patterns, resulting in monolayer 2D materials with locally different bandgaps;
- Control over the orientation of strain induced within the grown thin film, such as uniaxial or multi-axial strain, through the design of grayscale topographies, such as surfaces with unidirectional and multi-directional sinusoidal patterns;
- Direct growth of 2D materials to induce strain and to pre-determine the bandgap, eliminating the need for material transfer, which typically requires detachment of atomically thin material from growth substrate, alignment, and transfer to targeted substrate with a polymer stack. Well-defined growth conditions eliminate manual handling of the material, making the process consistently reproducible;
- Scalable and reproducible technique for inducing localized uniaxial, multi-axial and/or uniform tensile strain in 2D materials;
- Fully conformal attachment of 2D materials to the underlying dielectric, resulting in a stable and ideal semiconductor-dielectric interface for electronics and optics applications;
- Introduction of tensile strain on substrates having the same thermal expansion coefficient as the one of grown 2D material, or increased tensile strain on substrates having lower thermal expansion coefficient;
- After synthesizing the 2D material on a flat or grayscale topography, the synthesized/grown/deposited 2D material can be (further) shaped/patterned, optionally through further lithography and etching steps, to create isolated 2D material areas that can be used for device integration, such as in transistors and sensors. Due to the strong adhesion between the 2D material and the surface, varying levels of strain can be maintained, allowing for isolated 2D material with a varying bandgap and strain with different magnitudes and orientations;
- It is well known that tensile strain enhances electrical performance of 2D semiconductor in transistor configuration by boosting carrier mobilities in transistor channel. Therefore, electrically improved 2D semiconductors with ideal interface contact can be used in transistors, which can be integrated into any electronic and optical device with improved performance, offering higher speed and lower power consumption;
- Subsequent synthesis and/or growth and/or deposition of 2D materials and other layers, such as dielectric and conductive layers, can be repeated to achieve stacked channels, which are expected to extend Moore's law in transistors. Due to the topography of the stacked layers, tensile strain will still be induced in the stacked 2D channels;
- 2D semiconductors with varying bandgaps can be used in optical devices, such as photodetectors, sensors and light-emitting devices.

According to a second aspect of the present invention, there is provided a nanoelectronic device as recited in claim 13.

Other aspects of the invention are recited in the dependent claims attached hereto.

### BRIEF DESCRIPTION OF THE DRAWINGS

Other features and advantages of the invention will become apparent from the following description of non-limiting example embodiments, with reference to the appended drawings, in which:
Figure 1 shows schematics of theory of inducing *in-situ* strain in 2D materials during growth on grayscale substrates;
Figure 2 shows schematics of a possible fabrication method;
Figure 3 shows different example patterns on the thin film and on the 2D layer, as well as a comparison of strain for sinusoidal and triangular shapes (analytical calculations);
Figure 4 shows an experimental-proof-of-concept, where the bandgap shift in strained MoS₂ grown on silicon substrate is approximately 15 meV for calculated strain of approximately 0.15%;
Figure 5 shows an experimental-proof-of-concept, where the bandgap shift in strained MoS₂ grown on sapphire substrate is approximately 55-60 meV for calculated strain of approximately 0.6%;
Figure 6 shows schematics of a possible application: strained complementary FETs (CFETs) with stacked strained 2D transistors, serving as a potential roadmap for strained stacked complementary FETs with 2D semiconductors;
Figure 7 shows schematics of another possible application: processors, transparent and/or see-through electronics as well as flexible electronics using stacked strained 2D transistors. Transistors fabricated on opaque or transparent and/or flexible substrates according to the present invention can be used to fabricate complete devices. Different materials can be used from the beginning of strained transistor fabrication, or they can be integrated by techniques such as bonding; and
Figure 8 shows analytical calculations for induced tensile strain in monolayer MoS₂.

### DETAILED DESCRIPTION OF EMBODIMENTS OF THE INVENTION

Some embodiments of the present invention are explained in the following in more detail. The term "comprise" is used herein as an open-ended term. This means that an object encompasses all the elements listed, but may also include additional, unnamed elements. Thus, the word "comprise" is interpreted by the broader meaning "include", "contain" or "comprehend". Identical or corresponding functional and structural elements which appear in the different drawings are assigned the same reference numerals. Different drawings are not necessarily drawn to scale. It is to be noted that the use of words "first", "second" and "third", etc. may not imply any kind of particular order or hierarchy unless this is explicitly or implicitly made clear in the context.

The subject-matter described in the following will be clarified by means of a description of those aspects which are depicted in the drawings. It is however to be understood that the scope of protection of the invention is not limited to those aspects described in the following and depicted in the drawings; to the contrary, the scope of protection of the invention is defined by the claims. Moreover, it is to be understood that the specific conditions or parameters described and/or shown in the following are not limiting the scope of protection of the invention, and that the terminology used herein is for the purpose of describing particular aspects by way of example only and is not intended to be limiting.

Unless otherwise defined, technical and scientific terms used herein have the same meaning as commonly understood by one of ordinary skill in the art to which this invention belongs. Further, unless otherwise required by the context, singular terms shall include pluralities, and plural terms shall include the singular. Specific method steps and techniques of the present invention may be performed according to conventional methods well known in the art and as described in various general and more specific references that are cited and discussed throughout the present specification unless otherwise indicated. Further, for the sake of clarity, the use of the terms "about" or "approximately" is herein intended to encompass a variation of +/- 25% of a given value.

The following description will be better understood by means of the following definitions.

As used in the following and in the appended claims, the singular forms "a", "an" and "the" include plural referents unless the context clearly dictates otherwise. Also, the use of "or" means "and/or" unless stated otherwise. Similarly, "comprise", "comprises", "comprising", "include", "includes" and "including" are interchangeable and not intended to be limiting. It is to be further understood that where for the description of various embodiments use is made of the term "comprising", those skilled in the art will understand that in some specific instances, an embodiment can be alternatively described using language "consisting essentially of" or "consisting of".

In the context of the present description, the expression "operatively connected" and similar reflects a functional relationship between the several components of the device or a system among them, that is, the term means that the components are correlated in a way to perform a designated function. The "designated function" can change depending on the different components involved in the connection. A person skilled in the art would easily understand and figure out what are the designated functions of each and every component of the device or the system of the invention, as well as their correlations, on the basis of the present description.

The expression "thin film" relates to the thin form factor of a layer, sheet, membrane or film according to the invention. Generally speaking, a "thin film" as used herein relates to a layer of a material having a thickness much smaller than the other dimensions, e.g. at least one fifth compared to the other dimensions, and a thickness generally comprised between 0.3 nm and 500 µm, depending on the needs and circumstances, e.g. the manufacturing steps used to produce it. Typically, a thin film is a sheet-like structure having an upper surface and a bottom surface, with any suitable shape. In some embodiments, thin films according to the invention may have a thickness comprised between 0.3 nm and 500 µm, such as between 0.3 nm and 10 nm, between 1 nm and 50 nm, between 20 nm and 100 nm, between 200 nm and 500 nm, between 50 nm and 1 µm, between 1 µm and 50 µm, between 50 µm and 150 µm, 100 µm and 500 µm or between 200 µm and 500 µm.

As used herein, a "two-dimensional" or "2D" layer, sheet, polymer, film, membrane and the like is a sheet-like, macromolecule of elements or crystal having a thickness in the order of a few nanometers or less, such as a single molecule (monomolecular) layer, and 2D layers are therefore not retrievable in nature as freestanding structures. Perhaps the best-known example of a two-dimensional crystal is graphene, an individual, atomically thin layer or sheet of graphite. However, in a broader sense, a 2D structure may comprise more than one monolayer, such as two or three stacked monomolecular layers, and still be considered as two-dimensional in nature. Two-dimensional materials, sometimes also referred to as layered materials, may comprise laterally connected repeat units (monomers) or may be composed of single or few atomic elements. These materials have found use in applications, such as photovoltaics, semiconductors, electrodes and water purification, to cite a few. Layered combinations of different 2D materials are generally called van der Waals heterostructures and are contemplated in the context of the present invention.

A "covalent network solid" is crystalline solid in which atoms of similar or dissimilar elements are held together in a network of single bonds. The atoms of a covalent network solid are bonded by covalent bonds in a continuous network extending throughout the material. In a covalent network solid, there are no individual molecules, and the entire crystal or amorphous solid may be considered a macromolecule. Examples of covalent network solids include diamond with a continuous network of carbon atoms and silicon dioxide or quartz with a continuous three-dimensional network of SiO₂ units. Graphite and the mica group of silicate minerals structurally consist of continuous two-dimensional sheets covalently bonded within the layer, with other bond types holding the layers together. Examples of 2D covalent network solids include graphene, boron nitride, and transition metal dichalcogenides, such as molybdenum ditelluride (MoTe₂), molybdenum disulfide (MoS₂) and molybdenum diselenide (MoSe₂), as well as heterostructures such as MoS₂/MoTe₂ sheets.

As used herein, "3D surface feature" or "surface feature" are terms used to refer to any surface structure, shape, void, cavity, etc., such as but not limited to dots, protrusions, depressions, channels (trenches), etc., having any dimensions. Referring to Figure 1, although preferred but non-limiting, devices 1 herein are described as including thin films 3 with 3D surface features thereon having in this example at least one nanoscale dimension of 1000 nm or less. The dimensions referred to here concern in particular pitch p, surface length I and depth d as shown in Figure 1. It is within the scope of the present invention that the 3D surface features may have all or some of them dimensions greater than 1 nm, 10 nm, 100 nm or even 1000 nm, for instance comprised between 1 nm and 500 µm or between 1 nm and 1000 nm. As a non-limiting example, 3D surface features could have dimensions in the range of 1 nm to 500 nm or even more, or in the range of 20 nm to 50 nm, 1 nm to 10 nm, 1 m to 20 nm, or 1 µm to 100 µm. Preferably, the aspect ratio (i.e., the ratio of its dimensions in different mutually orthogonal directions; e.g., depth-to-pitch ratio) of the 3D surface features is at least five percent, depending on the materials and application. The term "structured" or "patterned" is used to describe a surface or area in which one or more 3D surface features have been created. In other words, the surface is shaped and is thus non-flat.

A nanoelectronic device refers to an electronic device, which is at least partially produced by using nanotechnology. In other words, a nanoelectronic device refers to an electronic device, in which at least some of the features of the device are in the range of nanometers, tens of nanometers or hundreds of nanometers (i.e., preferably smaller than 1 µm). However, the greatest dimension of the device itself may be greater than 1 µm.

According to a first aspect, the invention features a method to strain a two-dimensional layer of a solid material 5, comprising the steps of:
- providing a substrate 4;
- adding a thin film 3 of a patternable material onto the substrate 4 to be in direct contact with the substrate 4, or onto one of one or more first interlayers placed on the substrate 4 to be in indirect contact with the substrate 4;
- patterning the thin film 3; and
- adding, through a high-temperature process, a two-dimensional layer of solid material 5 onto the patterned thin film 3 to be in direct contact with the patterned thin film 3, or onto one of one or more second interlayers placed on the patterned thin film (3) to be in indirect contact with the patterned thin film (3).

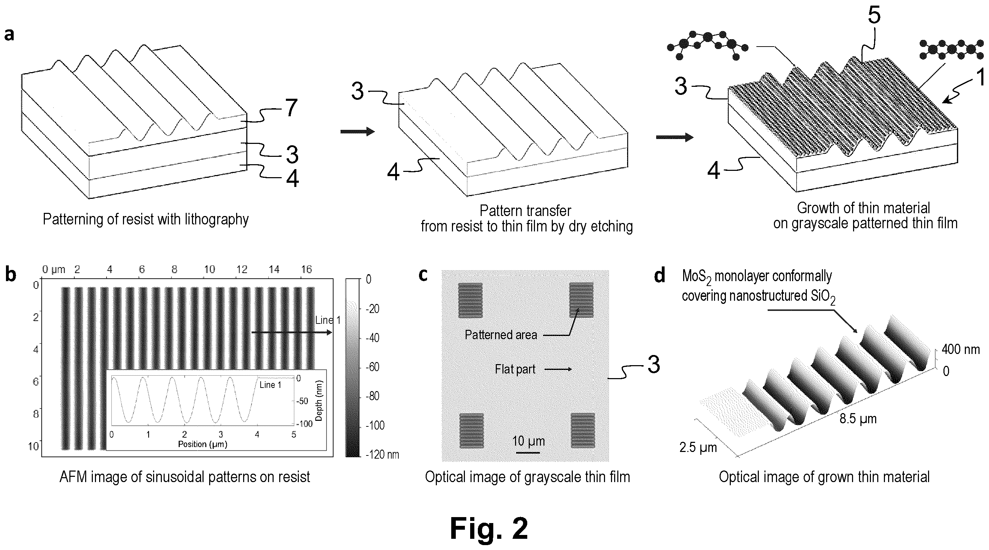

The proposed strain-engineering method for a nanoelectronic device is illustrated in Figures 1 and 2. The right-hand side of Figure 1 shows how the 2D layer 5 is added on the patterned thin film 3. The verb adding according to the present invention covers the operations of depositing, growing, and/or synthesizing the 2D layer onto the thin film. Once the thin film 3 has been patterned, the temperature is increased to T_{growth}, which is preferably a temperature greater than 200 °C as is explained later. This causes the materials to expand in response to an increase in temperature. The 2D layer of solid material, which may optionally be a covalent network solid, is then added onto the patterned thin film 3 through a high-temperature synthesis process to be in direct contact with the thin film, or to be in indirect contact with the thin film by means of one or more interlayers placed between the 2D layer and the thin film. Thus, if the 2D layer is not in direct contact with the thin film, the presence of interlayers creates an indirect contact interface between the 2D layer and the patterned thin film. The temperature is then decreased to room temperature (RT) causing the materials to shrink.

Figure 2 illustrates how the thin film 3 is patterned. As shown, a resist 7 is first deposited on the thin film 3. The resist 7 is then patterned by using lithography. The resist may or may not have substantially the same pattern as the pattern to be formed on the thin film 3. The resist has targeted design patterns that take into account shape deformation and changes that occur during the dry etching process, including rounding, lateral etching, and side profile angle variations. The resist pattern is then transferred to the thin film by dry etching. During this transfer, depending on the etch selectivity between the resist and the thin film, the vertical height of the pattern of the thin film can be amplified, reduced, or it remains unchanged. In the process, the resist is removed. After this, the 2D material 5 is added onto the patterned thin film 3 as explained above. It is to be noted that the dimensions given in Figure 2 are merely non-limiting example values.

In preferred embodiments, the substrate 4 has a higher thermal expansion coefficient *α* than the material of the thin film 3, for tensile strain. In preferred embodiments, the material of the thin film 3 is a dielectric material. According to one example, the material of the thin film is not a polymeric patternable material, such as thermoplastics, but rather an amorphous or crystalline material, such as silicon or silicon oxide, or another dielectric material. For instance, silicon thin film placed on sapphire substrate (rather than SiO₂) would be a good option thanks to thermal expansion mismatch between the silicon thin film and the sapphire substrate. In the embodiments illustrated in the figures, the substrate 4 is flat or substantially flat, but the substrate could instead have any arbitrary side profile. Alternatively, or in addition, the substrate may have any shape when seen from the top. Furthermore, the substrate is not limited to any particular size.

In the context of the present invention, the expression "high-temperature process" relates to those fabrication or manufacturing processes that involve the use of a high-temperature process for adding one or more layers of a material, such as chemical vapor deposition. Accordingly, the expression "high-temperature" refers herein to processes carried out at temperatures above room temperature, such as for instance above 100 °C, for example at 200 °C or more.

In embodiments, the substrate 4 is an element made of sapphire or silicon.

In embodiments, the thin film 3 is a film or layer of SiO₂. In embodiments, the thin film is deposited by a thermal growth process, such as a dry or wet thermal growth process. In embodiments, the thin film is deposited by chemical vapor deposition (CVD), such as plasma-enhanced chemical vapor deposition (PECVD). Preferably, in the previous embodiment, the material of the thin film 3 is a dielectric material.

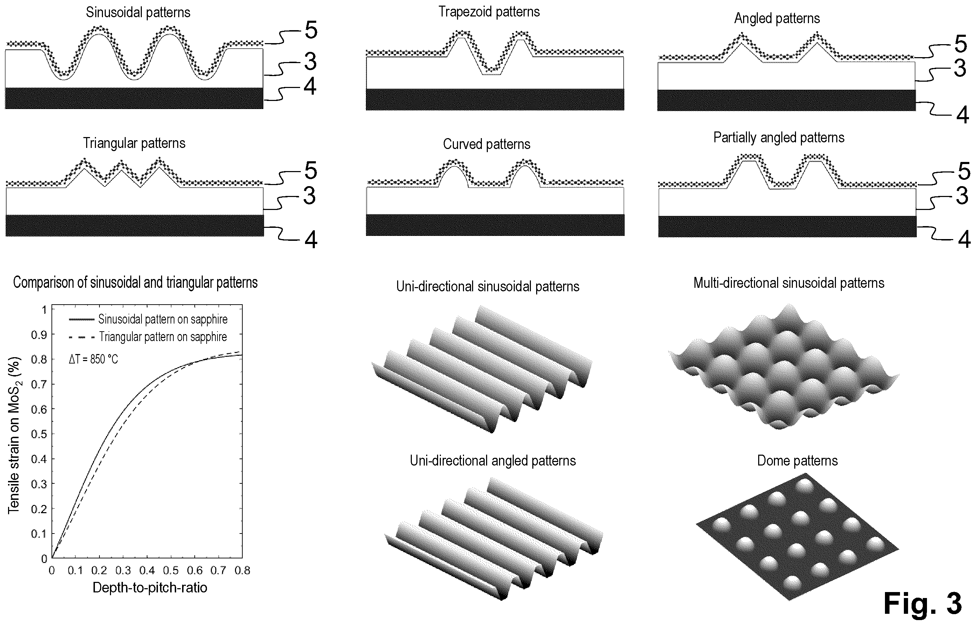

In embodiments, the patterning is performed in a way to provide grayscale nanopatterns, in particular having sinusoidal, triangular, trapezoidal, rounded, angled and/or curved side profiles in one or more directions, as shown in Figure 3.

In embodiments, the patterning is performed by thermal scanning probe lithography (t-SPL). In alternative embodiments, the patterning is performed by thermal nanoimprint lithography of a polymeric deformable substrate forming a resist coated onto the thin film of a patternable material, such as a dielectric material.

In embodiments, the 2D layer 5 is grown via metal-organic chemical vapor deposition (MOCVD).

In embodiments, the 2D layer 5 is a MoS₂ two-dimensional layer.

The method according to the invention can be employed to perform various forming approaches, including but not limited to conformal shaping, uniform bending and lateral compression, preferably without unintentionally fracturing or cracking the nanomaterials. Such a capability can also be used to change various properties of nanomaterials, for example, electrical and optical properties, which may provide opportunities for developing miniature devices, for example, for use in electronics. According to a non-limiting aspect of the invention, local strains may be induced in nanomaterials to modify the bandgap of the material (energy range in a solid where no electron states exist). The bandgap of the material can be increased or decreased depending on thermal expansion coefficients at play, according to the needs and circumstances. An additional non-limiting aspect of the invention is the capability of inducing local strains in 2D nanomaterials to bend or pattern the 2D nanomaterials to create 3D shapes or features on the 2D materials.

Advantageously, individual method steps can be performed according to standard microfabrication manufacturing processes, thereby facilitating production and scalability of items for use in diverse applications, including electronics, semiconductor industry and optoelectronic devices, as will be detailed later on. Additional advantages compared to processes for engineering thin films, particularly two-dimensional layers of solid materials, include the possibility to induce a uniform strain, obtaining a conformal contact with the underlying substrate, which may be deformable, as well as the avoidance of any slippage between the 2D material and the below substrate.

The method according to the present invention is particularly suitable for patterning surface features on thin films and/or 2D layers. Possible 2D materials include, but are not limited to: graphene; black phosphorus; GaS; GaSe; GaTe; MX2 type of dichalcogenides where M=Mo, Nb, Ni, Sn, Ti, Ta, Pt, V, W, or Hf and X=S, Se, or Te; M2X3 type of trichalcogenides where M=As, Bi, or Sb and X=S, Se, or Te; MPX3 where X=S or Se; MAX3 where A=Si or Ge and X=S, Se, or Te; and alloy sheets like MxM'1-xS2, as well as combinations of any of the foregoing. Accordingly, suitable materials include molybdenum disulfide (MoS₂), molybdenum diselenide (MoSe₂), molybdenum ditelluride (MoTe₂), tungsten disulfide (WS₂), tungsten diselenide (WSe₂), tungsten ditelluride (WTe₂), chromium disulfide (CrS₂), chromium diselenide (CrSe₂), chromium ditelluride (CrTe₂), gallium arsenide, germanium, boron nitride (hBN) and gallium indium phosphide. These materials typically have the ability to support sufficient elastic strain and accordingly a significant change in the bandgap, therefore exhibiting desirable (opto)electronic properties. Other (opto)electronic materials may also include more conventional solid materials capable of supporting sufficient elastic strain. For example, a crystalline, polycrystalline, and/or amorphous silicon nanosheet can sustain tensile strain of a few percent which is sufficient to induce significant change in the bandgap.

In embodiments of the invention, the thin film or layer of solid material is a two-dimensional layer of (a) covalent network solid material(s), such as a monolayer, a bilayer or a multilayer of (a) covalent network solid material(s). Two-dimensional layers of (a) solid material(s), such as graphene or transition metal dichalcogenides, are known for their unusual and intriguing mechanical, electronic and optoelectronic properties that make them promising for a wide range of applications, and is therefore highly desirable to pattern surface features thereon for engineering the same.

The substrate 4 may optionally be made deformable, i.e. flexible. A deformable substrate used according to preferred aspects of the invention include thermally deformable polymeric materials, and particularly one or more thermoplastic materials and/or one or more elastomeric materials. A non-exhaustive list of suitable materials includes thermoplastics, such as a polycarbonate, polyetherimide (PEI), polyamide, polyimide, polysulfone, polyethersulfone (PES), polyphenylene oxide (PPO), polyether ether ketone (PEEK), polyphenylene sulfide (PPS), polyhydroxyether, styrene-butadiene, polyacrylate, polyacetal, polybutyleneterephthalate, polyamide-imide, poly(ether ether sulfone) (PEES), blends thereof, or a copolymer thereof, such as PES/PEES with various repeat unit ratios, PES homopolymers or PEES homopolymers, elastomeric materials, such as silicone rubber (e.g. polydimethylsiloxane PDMS) or fluorosilicone rubber, thermoplastic elastomers, such as styrenic block copolymer (SBC), ethylene propylene diene monomer (EDPM) rubber, butyl rubber, nitrile rubber, acrylonitrile butadiene styrene (ABS), polystyrene (PS), polyethylene (PE), polypropylene (PP), polyphthalaldehyde (PPA), polymethyl methacrylate (PMMA) and the like, as well as combinations of the foregoing.

As it will be apparent, another object according of the invention relates to an article of manufacture obtainable by the method of the invention, as well as a device comprising an article of manufacture according to the invention. The article of manufacture may comprise or consist of a patterned thin film of (a) solid material(s) or a patterned thin film of (a) solid material(s) placed on a (patterned) substrate. More specifically, the article of manufacture according to the present embodiment comprises a first substrate; a patterned thin film placed or disposed on the substrate, in this case directly on the substrate, and a 2D layer of solid material placed or disposed above or on the patterned thin film, optionally directly on the thin film, wherein the pattern or at least the side profile of the pattern of the 2D layer follows the shape and dimensions of the pattern of the thin film (i.e. the 2D layer is conformally placed above the thin film to be in direct or indirect contact with the thin film). The thermal expansion coefficient of the substrate is optionally greater than the thermal expansion coefficient of the thin film. The 2D layer is in this case grown onto the thin film at a high temperature, i.e. at a temperature greater than 100 °C, or more specifically at a temperature greater than 200°C or 600°C, for example at a temperature comprised between 300°C and 900°C. The 2D layer is thus a high-temperature-grown layer.

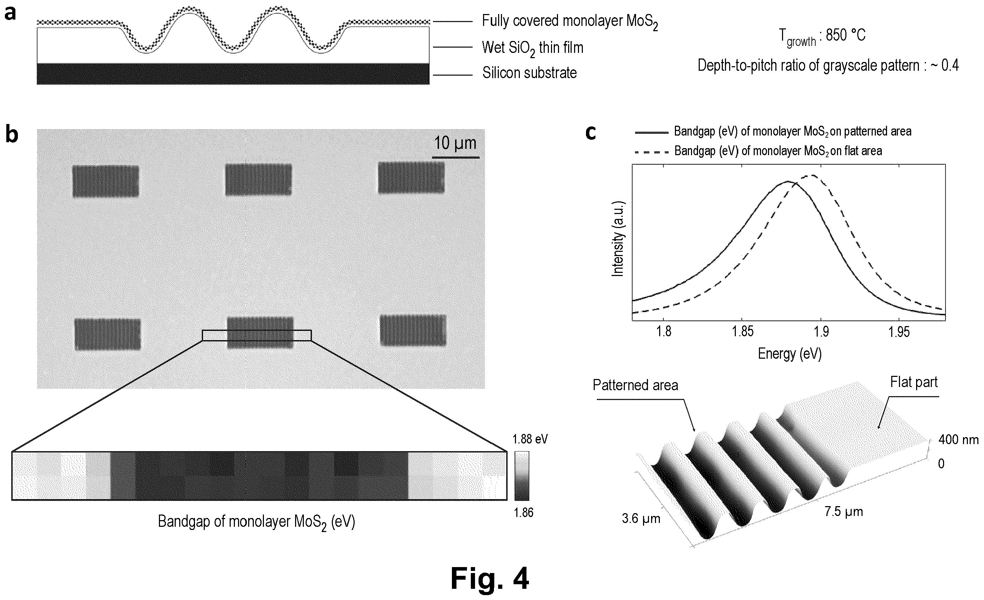

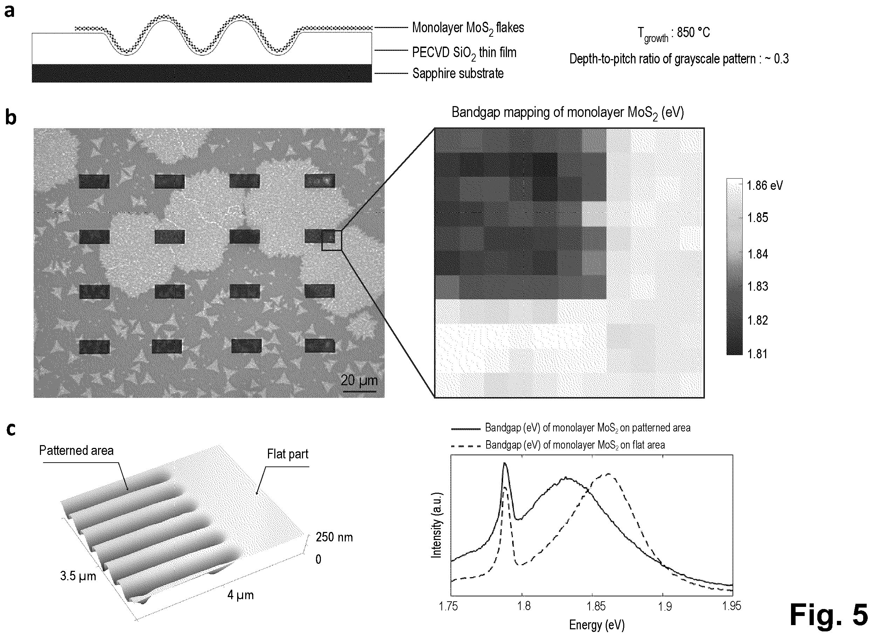

Figure 4 shows an experimental-proof-of-concept of the device 1, where the bandgap shift in strained MoS₂ grown on a silicon substrate is approximately 15 meV for calculated strain of approximately 0.15%. Figure 5 shows an experimental-proof-of-concept of the device 1, where the bandgap shift in strained MoS₂ grown on a sapphire substrate is approximately 55-60 meV for calculated strain of approximately 0.6%.

A device of the invention can be a next-generation device characterized by the need of some components to have a nanometric or micrometric scale and/or nanometric or micrometric 3D surface features. In embodiments of the invention, such a device can be for instance a light emitting device, an optoelectronic device, a semiconductor electronic component or device, chemical sensor, strain sensor, mechanical sensor, magnetic field sensor, Hall sensor, biosensor, quantum computing device, single-electron device, memory and storage device, processor, and component or device for micro/nano systems. Concrete examples include for instance:
Strained transistors, stacked transistors and strained complementary-FETs (C-FETs). A strained 2D semiconductor can significantly enhance the performance of stacked transistors and strained C-FETs by providing higher carrier mobility, enhanced on/off current ratio and improved electrical characteristics. This invention enables the fabrication of both stacked transistors and transistors with a single nanoscale semiconducting channel. Strained 2D material having carrier mobility similar to a silicon with a thickness greater than 5 nm enable further scaling down device dimensions, which is essential for maintaining Moore's Law and for developing next-generation electronic devices. Additionally, low off-current state provides low power consumption. This is crucial for the development of energy-efficient electronics, extending battery life in portable devices and reducing energy costs in large-scale data centers.

Faster sensors (optical, chemical, biological): The enhanced carrier mobility as well as modified adjustable bandgap engineering in strained 2D materials results in faster and more sensitive sensors. These materials can detect instant changes, making them ideal for applications in medical diagnostics, environmental monitoring, and security.

Transparent and/or see-through electronics: In addition to aesthetic concerns, the use of 2D materials, which are inherently transparent, allows for the development of transparent and/or see-through electronic devices. This can revolutionize display technologies, leading to innovative products, such as smart windows and head-up displays.

Flexible electronics: High-performance electronics on flexible substrates can open new possibilities in consumer electronics, such as foldable smartphones and wearable electronics.

Neuromorphic processors: 2D materials have been used for neuromorphic computing. This can lead to more efficient artificial intelligence systems with improved learning capabilities and lower energy consumption.

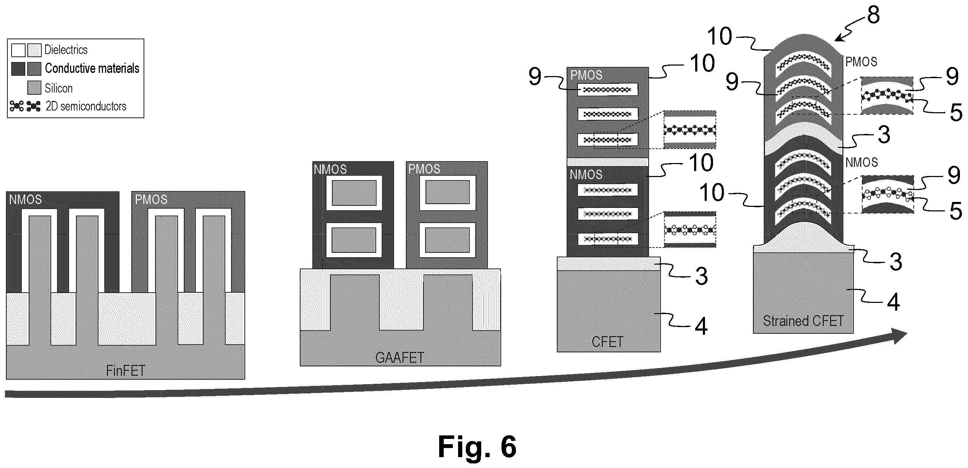

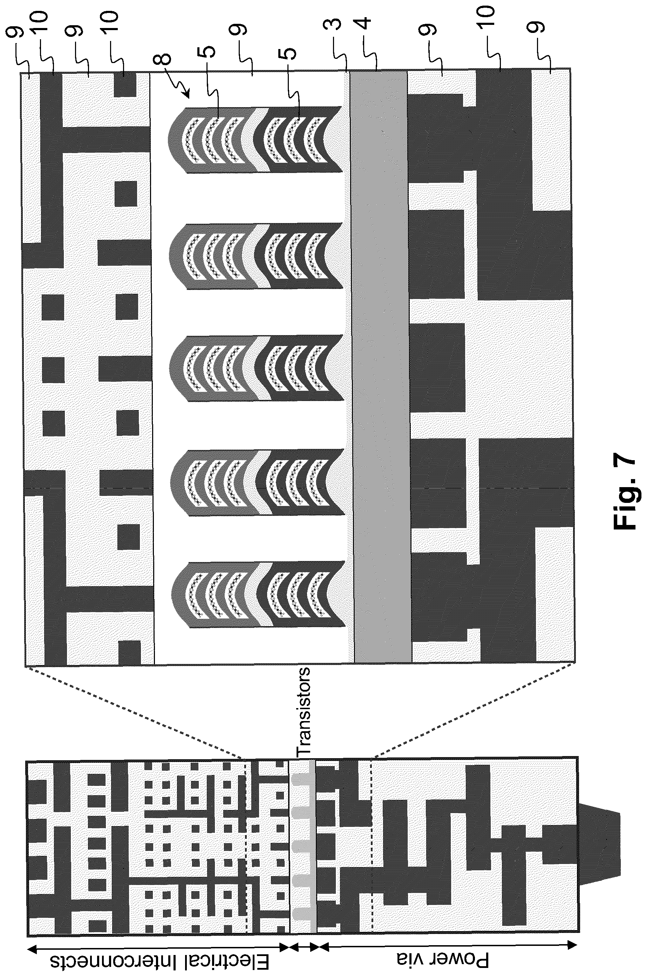

For applications beyond FETs, an additional dielectric-conductive layer can be added to the conductive-dielectric-semiconductor configuration shown in Figures 6 and 7 to create floating-gate field-effect transistors (FGFETs). These can be used for logic-in-memory devices and neuromorphic computing applications.

Optical detectors and light emitting devices: Strained 2D materials can enhance the performance of optical detectors and light-emitting devices. Their tunable bandgaps and strong light-matter interactions make them ideal for applications in photodetectors, LEDs, and laser diodes.

Figure 6 shows schematics of a possible application, where a strained complementary FETs (CFET) with stacked strained 2D transistors 8 serves as a potential roadmap for strained stacked complementary FETs with 2D semiconductors. As can be seen, the stacked transistors 8 are formed by the 2D layers 5 embedded in dielectric elements or layers 9, which in turn are embedded in an electrically conductive element or layer 10.

Figure 7 shows schematics of another possible application, where transparent and/or see-through electronics and flexible electronics use stacked strained 2D transistors 8. Transistors 8 fabricated on transparent and/or flexible substrates 4 according to the present invention can be used to fabricate complete devices. Different materials can be used from the beginning of strained transistor fabrication, or they can be integrated by techniques such as bonding.

In the following, example devices having a strained monolayer MoS₂ on SiO₂ thin film, which in turn is placed on sapphire or silicon substrates are discussed.

For sapphire substrates, 500 nm of SiO₂ forming a thin film is deposited by plasma-enhanced chemical vapor deposition (PECVD) technique at 320 °C. Then, thermally sensitive resist, polyphthalaldehyde (PPA), is spin-coated on the SiO₂ film, which is on the sapphire substrate and patterned with grayscale nanopatterns, such as sinusoidal and triangular shapes, using thermal scanning probe lithography (t-SPL). The patterns are transferred from the resist to the SiO₂ layer by dry plasma etching. As an alternative approach, a thermoplastic resist is spin-coated onto the SiO₂ layer on the sapphire substrate and shaped using thermal nanoimprint lithography, where previously patterned substrates are used as imprinting stamps. For silicon substrates, 500 nm SiO₂ is deposited by wet thermal growth process, and the same fabrication steps to obtain grayscale patterns on the oxide are repeated. Later, the patterned substrates are loaded into a CVD chamber, where material growth is realized, and heated to the target temperature of 850 °C. At 850 °C, monolayer MoS₂ is grown using the metal-organic chemical vapor deposition (MOCVD) method. After the 2D material growth process, the substrates are naturally cooled down to room temperature.

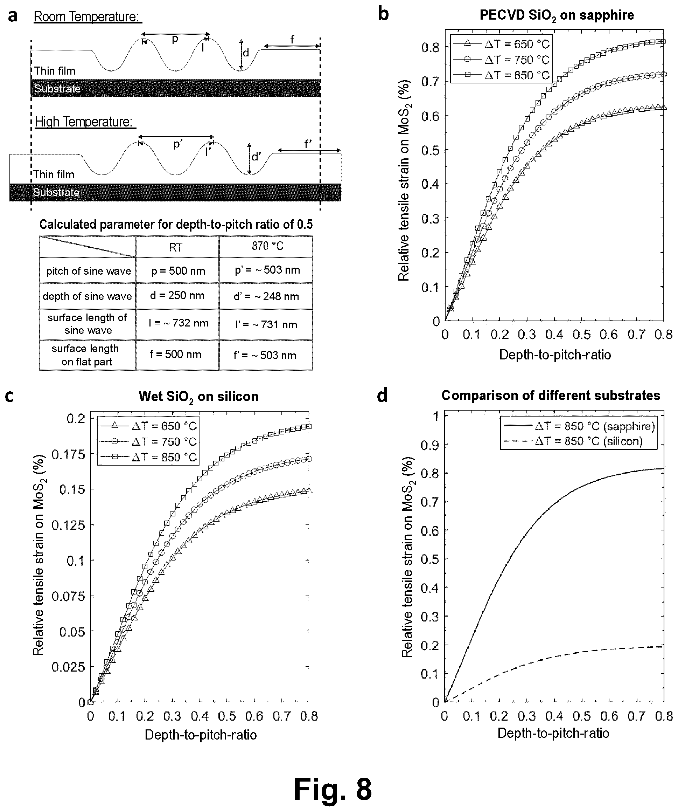

Theoretical calculations were performed for sinusoidal nanopatterns fabricated on PECVD SiO₂ having pitch of 500 nm and peak-to-peak depth of 250 nm on a c-plane sapphire substrate. The dimensions were calculated considering the thermal expansion coefficients of 7.5 × 10⁻⁶ K⁻¹ for the sapphire substrate and 0.24 × 10⁻⁶ K⁻¹ for PECVD SiO₂, as well as the Poisson ratio of 0.25 for PECVD SiO₂. The calculated dimensions are shown in the table of Figure 8.

For wet SiO₂ on a silicon substrate, the thermal expansion coefficients of 2.5 × 10⁻⁶ K⁻¹ for the silicon substrate and 0.56 × 10⁻⁶ K⁻¹ for wet SiO₂, as well as the Poisson ratio of 0.17 for wet SiO₂, are considered. For all cases, the thermal expansion coefficient of MoS₂ is considered to be 7.5 × 10⁻⁶ K⁻¹.

Due to the identical thermal expansion coefficients of MoS₂ and sapphire layers, the strain on MoS₂ grown on the flat surface of the SiO₂/sapphire substrates is calculated to be 0%. However, due to the mismatch in thermal expansion coefficients between MoS₂ and silicon, approximately 0.4% strain is expected on MoS₂ grown on a flat surface of SiO₂/silicon. In Figure 8, relative strain is shown for silicon and sapphire substrates.

The most significant parameter for obtaining high tensile strain on grown (and/or synthesized and/or deposited) materials is the thermal expansion coefficient difference between the relatively thick substrates (e.g., sapphire with thickness of 650 µm or silicon with thickness of 525 µm in the present example) and the 500 nm thick SiO₂ (a relatively thin film compared to the substrate). If the thermal expansion coefficient of 0.24 × 10⁻⁶ K⁻¹ and the Poisson ratio of 0.25 are kept constant for SiO₂, and the thermal expansion coefficient of the substrate increases from 2.5 × 10⁻⁶ K⁻¹ to 7.5 × 10⁻⁶ K⁻¹, the calculated relative tensile strain on the thin MoS₂ layer increases from 0.26% to 0.75%.

While the invention has been disclosed with reference to certain preferred embodiments, numerous modifications, alterations, and changes to the described embodiments, and equivalents thereof, are possible without departing from the sphere and scope of the invention. Accordingly, it is intended that the invention is not limited to the described embodiments and should be given the broadest reasonable interpretation in accordance with the language used therein.

## Claims

1. A method of straining a two-dimensional layer of solid material (5), the method comprising the steps of:
- providing a substrate (4);
- adding a thin film (3) of patternable material onto the substrate (4) to be in direct contact with the substrate (4), or onto one of one or more first interlayers placed on the substrate (4) to be in indirect contact with the substrate (4);
- patterning the thin film (3); and
- adding a two-dimensional layer of solid material (5) through a high-temperature process onto the patterned thin film (3) to be in direct contact with the patterned thin film (3), or onto one of one or more second interlayers placed on the patterned thin film (3) to be in indirect contact with the patterned thin film (3).

2. The method according to claim 1, wherein the substrate (4) is **characterised by** a first thermal expansion coefficient, and the patterned thin film (3) is **characterised by** a second thermal expansion coefficient, and wherein the first thermal expansion coefficient is different from the second thermal expansion coefficient, and wherein the first thermal expansion coefficient is optionally at least 2 × 10⁻⁶ K⁻¹ higher than the second thermal expansion coefficient.

3. The method according to claim 1 or 2, wherein the patternable material is a dielectric material.

4. The method according to any one of the preceding claims, wherein the two-dimensional layer (5) is a layer of a covalent network solid.

5. The method according to any one of the preceding claims, wherein the step of adding is performed at a temperature above room temperature, for example at 200 °C or more.

6. The method according to any one of the preceding claims, wherein the substrate (4) is made of sapphire or silicon.

7. The method according to any one of the preceding claims, wherein the thin film is made of dielectric, such as SiO₂, preferably deposited on the substrate (4) by a thermal growth process or by a chemical vapor deposition process.

8. The method according to any one of the preceding claims, wherein the patterning is performed in a way to provide grayscale nanopatterns, such as patterns having rounded, curved and/or angled side profiles, including sinusoidal-, triangular-, and/or trapezoidal-shaped side profiles in one or more directions to provide unidirectional, bidirectional, multidirectional or uniform strain orientations at least in the two-dimensional layer of solid material (5).

9. The method according to any one of the preceding claims, wherein the method further comprises depositing a resist layer (7) on the thin film (3), patterning the resist layer (7), and transferring the patterns from the resist layer (7) to the thin film (3) to pattern the thin film (3), wherein the resist layer (7) is optionally patterned by thermal scanning probe lithography or by thermal nanoimprint lithography, and wherein the patterns are optionally transferred from the resist layer to the thin film (3) by dry etching.

10. The method according to any one of the preceding claims, wherein the method further comprises adding one or more dielectric and/or electrically conductive interlayers onto the thin film (3) or onto the patterned thin film, and adding the two-dimensional layer of solid material (5) onto the one or more dielectric and/or electrically conductive interlayers, and/or wherein the method further comprises patterning the top side of the two-dimensional layer of solid material (5) to create one or more isolated regions in the two-dimensional layer of solid material (5).

11. The method according to any one of the preceding claims, wherein the two-dimensional layer of solid material (5) is added by a metal-organic chemical vapor deposition (MOCVD) process.

12. The method according to any one of the preceding claims, wherein the two-dimensional layer of solid material (5) is a MoS₂ two-dimensional layer.

13. A nanoelectronic device (1) comprising a substrate (4) **characterised by** a first thermal expansion coefficient; a patterned thin film (3) **characterised by** a second thermal expansion coefficient and placed on the substrate (4) to be in direct contact with the substrate (4), or placed on one of one or more first interlayers placed on the substrate (4) to be in indirect contact with the substrate (4), and a two-dimensional patterned layer of solid material (5) placed on the patterned thin film (3) to be in direct contact with the patterned thin film (3), or placed on one of one or more second interlayers placed on the patterned thin film (3) to be in indirect contact with the patterned thin film, wherein at least the side profile of the pattern of the two-dimensional layer of solid material (5) follows the shape and dimensions of the pattern of the thin film (3), and wherein the first thermal expansion coefficient is different from the second thermal expansion coefficient.

14. The device (1) according to claim 13, wherein the patterned thin film (3) has a thickness comprised between 0.3 nm and 500 µm, and/or wherein the pattern of the thin film (3), and/or the two-dimensional layer of solid material (5) has feature dimensions comprised between 1 nm and 500 µm, and/or wherein the device (1) comprises an arrangement of stacked transistors (8) placed directly or indirectly onto the patterned thin film (3).

15. The device (1) according to claim 13 or 14, wherein the device (1) is selected from a list comprising a processor, a light emitting device, an optoelectronic device, a semiconductor electronic component or device, a chemical sensor, a strain sensor, a mechanical sensor, a magnetic field sensor, a Hall sensor, a biosensor, a quantum computing device, a single-electron device, a memory and storage device, a component or device for micro/nano systems, including strained transistors, stacked transistors and strained complementary-FETs (C-FETs), a transparent and/or see-through electronics component or device, a flexible electronics component or device, a neuromorphic processor, a floating-gate field-effect transistor (FGFET), a LED, and a laser diode.
